Europäisches Patentamt

European Patent Office

Office européen des brevets

(11) Veröffentlichungsnummer: **0 222 297 B1**

(12) **EUROPÄISCHE PATENTSCHRIFT**

(45) Veröffentlichungstag der Patentschrift: **23.10.91**

(51) Int. Cl.⁵: **G03F 7/26, B41N 3/08**

(21) Anmeldenummer: **86115242.9**

(22) Anmeldetag: **04.11.86**

(54) **Einbrenngummierung für Offsetdruckplatten.**

(30) Priorität: **12.11.85 DE 3539992**

(43) Veröffentlichungstag der Anmeldung:
**20.05.87 Patentblatt 87/21**

(45) Bekanntmachung des Hinweises auf die
Patenterteilung:
**23.10.91 Patentblatt 91/43**

(84) Benannte Vertragsstaaten:
**AT BE CH DE FR GB IT LI NL SE**

(56) Entgegenhaltungen:
**EP-A- 0 012 956**
**DE-A- 1 447 901**
**FR-A- 1 345 382**
**GB-A- 1 448 838**
**US-A- 4 096 089**

(73) Patentinhaber: **HOECHST AKTIENGESELL-
SCHAFT**
**Postfach 80 03 20**
**W-6230 Frankfurt am Main 80(DE)**

(72) Erfinder: **Stahlhofen, Paul, Dr. Dipl.-Chem.**
**Leibnizstrasse 18b**
**W-6200 Wiesbaden(DE)**
Erfinder: **Mohr, Dieter, Dr. Dipl.-Chem.**
**Mainstrasse 5**
**W-6229 Schlangenbad(DE)**

## Beschreibung

Die Erfindung betrifft eine Einbrenngummierung für bestrahlte und entwickelte Offsetdruckplatten

Offsetdruckplatten bestehen im allgemeinen aus a) einem flächigen Trägermaterial aus Metallen und/oder Kunststoffen, deren Oberfläche beispielsweise durch Aufrauhen (Ätzen) und/oder anodische Oxidation modifiziert werden kann, und b) mindestens einer strahlungs(licht)empfindlichen Beschichtung (Reproduktionsschicht). Insbesondere bei positiv-arbeitenden Reproduktionsschichten, aber grundsätzlich möglich auch bei negativ-arbeitenden Reproduktionsschichten, wird bei der Herstellung einer Druckform mit den Grundarbeitsstufen Bestrahlen, Entwickeln und Gummieren (Konservieren, Desensibilisieren) zwischen den beiden letzten Stufen auch noch eine Einbrennstufe durchgeführt. Angewendet auf positiv-arbeitende Reproduktionsschichten kann man sich die Vorgehweise wie folgt vorstellen: Bei der bildmäßigen Bestrahlung (Belichtung) werden die von elektromagnetischer Energie (dem Licht) getroffenen Teile der Reproduktionsschicht löslich, die nicht getroffenen Teile bleiben unlöslich (jeweils bezogen auf den zu verwendenden Entwickler). Durch das Herauslösen der erstgenannten Teile in der Entwicklungsstufe entstehen auf der Druckplattenoberfläche nach dem Entwickeln der bestrahlten Reproduktionsschicht die beim späteren Drucken von der Druckform wasserführenden Nichtbildstellen und aus den letztgenannten Teilen die beim späteren Drucken farbführenden Bildstellen. In der Praxis hat es sich herausgestellt, daß eine Erhitzung der bestrahlten und entwickelten Druckplatte - je nach Art des Trägermaterials und/oder der Reproduktionsschicht auf mehr als 180 ° C zu höheren Druckauflagen mit der daraus resultierenden Druckform führen kann. Dieser Vorgang wird als "Einbrennen" bezeichnet. Durch das Einbrennen wird eine Verfestigung der Bildstellen erreicht, wobei diese beispielsweise unlöslich in den üblichen organischen Lösemitteln und resistent gegen die Einwirkung von Chemikalien werden.

Da beim Einbrennen auch Bestandteile der Bildstellen (d. h. der Reproduktionsschicht), z. B. Bestandteile des Bindemittels, in die Nichtbildstellen gelangen können und damit deren Hydrophilie negativ beeinflussen, was beispielsweise zum Tonen (Annahme von Druckfarbe in den Nichtbildstellen) führt, mußten in der Anfangsphase des Einsatzes einer Einbrennstufe die Verunreinigungen in den Nichtbildstellen mit relativ aggressiven Lösungen wieder entfernt werden.

Im Laufe der Zeit wurden dann sogenannte "Einbrennhilfen" entwickelt, welche diese Nachreinigung zumindest erleichterten, aber im Regelfalle doch noch eine Reinigung der Nichtbildstellen mit Wasser vor dem eigentlichen Druckvorgang erforderlich machten. Zu den aus dem Stand der Technik bekannten Einbrennhilfen zählen u.a. die folgenden:

In der DE-C 23 18 286 (= US-A 3 745 011) wird ein Verfahren zur Herstellung negativer Resistbilder beschrieben, bei dem ein Photoresist nach dem Belichten, Entwickeln und vor einem Einbrennprozeß mit einer Lösung einer cycloaliphatischen, heterocyclischen oder aromatischen Polycarbonsäure oder einer aromatischen Sulfonsäure behandelt wird. Die lichtempfindlichen Schichten der eingesetzten Photoresists enthalten natürliche Proteine wie Fischleim und Ammoniumbichromat. Diese Behandlung vor dem Einbrennen soll a) die Einbrenntemperatur erniedrigen, b) die Ätzmittelbeständigkeit des Resistbildes erhöhen und c) die Abstreifbarkeit des Resistbildes bzw. des aufgebrachten Photoresists verbessern. Zu den eingesetzten Säuren zählen u.a. auch p-Toluolsulfonsäure, 2-Naphthalinsulfonsäure, Naphthalin-1,8-disulfonsäure, Benzolsulfonsäure und 1,3-Benzoldisulfonsäure, die vorzugsweise in 1- bis 25%iger Lösung eingesetzt werden. Als Trägermaterial für die Beschichtung mit Photoresist wird ausschließlich Stahl verwendet. Das Anwendungsgebiet Druckplatten und die dortige spezielle Einbrennproblematik werden nicht erwähnt.

Aus der DE-C 25 30 422 (= GB-A 1 513 368) ist ein Verfahren zum Herstellen von Druckformen, Platten für gedruckte Schaltungen, integrierte Schaltkreise und dgl. bekannt, bei dem die belichteten und entwickelten Schichtträger vor dem Einbrennen zumindest auf den Nichtbildstellen mit einer Schutzschicht versehen werden. Diese Schutzschicht verbleibt während des Einbrennens auf dem Schichtträger und ist nach dem Einbrennen zusammen mit einem Niederschlag, der sich während des Einbrennens auf der Schutzschicht absetzt, mit Wasser entfernbar. Die Schutzschicht wird in Form einer etwa 2,5- bis 45%igen wäßrigen Lösung einer der folgenden Verbindungen aufgebracht: Na-dodecylphenoxybenzoldisulfonat, Na-Salz einer alkylierten Naphthalinsulfonsäure, Di-Na-methylendinaphthalindisulfonat, Na-dodecyl-benzolsulfonat, Na-Salz eines sulfonierten Alkyldiphenyloxids, $NH_4$-perfluoralkylsulfonat, K-perfluoralkylsulfonat, Na-dioctylsulfosuccinat, Na-di(methylamyl)-sulfosuccinat und $LiNO_3$.

In der auf diese Veröffentlichung zurückgehenden GB-A 1 575 200 wird vor dem Einbrennen zusätzlich zu einer der vorstehend aufgeführten Verbindungen noch ein wasserlösliches Hydrokolloid aus der Gruppe Gummi arabicum, Na-carboxymethylcellulose oder Alginat der wäßrigen Lösung zur Erzeugung der Schutzschicht beigefügt. Das eingesetzte Stoffgemisch soll zu 85 bis 98 Vol.-%

aus einer der aus der vorstehenden DE-C bekannten Verbindungen und zu 2 bis 15 Vol.-% aus einem der Hydrokolloide bestehen und wird in 10 bis 50 vol.-%iger wäßriger Lösung eingesetzt. Nach dem Einbrennen werden die Druckformen mit Wasser gewaschen und können dann in eine Druckmaschine eingespannt werden.

Die Einbrennhilfe gemäß der DE-C 26 25 336 (= US-A 4 063 507) ist Borsäure oder ein Borat und wird in fester Form oder vorzugsweise in 3- bis 10%iger wäßriger Lösung eingesetzt.

Nach der DE-A 26 26 473 (= GB-A 1 555 233) können anstelle der bereits vorstehend als geeignet für das Einbrennen von Druckplatten beschriebenen Verbindungen (Einbrennhilfen) u.a. auch noch verschiedene hydrophile Polymere wie Gummi arabicum, Dextrin, Polyvinylalkohol, Celluloseether, Homo- und Mischpolymerisate auf der Basis von Acryl- oder Methacrylsäure oder ein Mischpolymerisat aus Alkylacrylat und Vinylmethylacetamid oder auch Salze organischer Säuren wie Di-Na-anthrachinon-2,7-disulfonat, Tri-Na-naphthalin-1,3,5-trisulfonat, Tri-Na-1-naphthylamin-4,6,8-trisulfonat oder Tri-Na-1-naphthol-3,6,8-trisulfonat eingesetzt werden. Die Verbindungen werden in wäßriger Lösung einer Konzentration von 0,1 % bis zur Sättigung angewandt.

Als weitere Einbrennhilfen werden in der EP-A 0 043 991 (= US-A 4 355 096) Carboxylgruppen enthaltende Amine wie Ethylendiamintetraessigsäure, Nitrilotriessigsäure oder deren Salze und in der US-A 4 191 570 Salze oder salzartige Reaktionsprodukte aus Naphthalin, Formaldehyd und Schwefelsäure aufgeführt.

Die bekannten Einbrennhilfen weisen aber alle noch mehr oder weniger große Nachteile auf. Beispielsweise können sie bei den Bildstellen eine Reduzierung der Oleophilie bewirken, sie können zu Fleckenbildung auf der Druckplattenoberfläche und - insbesondere bei ungenügender Nachreinigung mit Wasser oder wäßrigen Entwicklerlösungen - zu Störungen des Wasser/Druckfarbe-Gleichgewichts beim späteren Drucken führen. In vielen Arbeitsanweisungen zur Anwendung der bekannten Einbrennhilfen wird speziell auf diese Problematik hingewiesen, die beispielsweise durch Trockenreiben der Druckplattenoberfläche vor dem Einbrennen, sorgfältiges Nachwaschen oder auch [beispielsweise EP-B 0 012 956 (= US-A 4 265 999)] hydrophilierendes Nachbehandeln/Reinigen mit einer wäßrigen Lösung eines hydrophilen Polymeren wie Polyvinylphosphonsäure behebbar sein soll. Solche speziellen hydrophilierenden oder auch eine der üblichen gummierenden (konservierenden) Nachbehandlungen sind prinzipiell möglich, erfordern aber bei der Herstellung und Anwendung einer Druckform einen zusätzlichen Arbeitsschritt. Eine Kombination beider Schritte in einer Einbrenngummierung wird zwar in der weiter oben dargestellten GB-A 1 575 200 beschrieben, sie führt jedoch immer noch zu einem großen Papierverbrauch in der Druckmaschine, da sich - ohne eine zusätzliche Zwischenreinigung - die Druckform zu langsam freiläuft.

In der EP-A 0 155 620 wird eine aus mehreren Komponenten bestehende Einbrenngummierung vorgeschlagen, bestehend aus einem hydrophilen Polymeren, einer wasserlöslichen organischen Carbon- oder Sulfonsäure oder einem ihrer wasserlöslichen Salze, einer Hydroxypolycarbonsäure und/oder deren Salze, einem Alkandiol und einem Tensid. Eine mit diesem Einbrennhilfsmittel behandelte Druckform muß nach dem Einbrennen nicht mehr abgewaschen werden, sondern kann direkt in die Druckmaschine eingespannt werden. Hier wird eine relativ große Zahl an Komponenten eingesetzt, und es kann vorkommen, daß bei zu dicker Konservierung, wie es in der Praxis bei der manuellen Behandlung oft geschieht, die Druckschablone während des Einbrennens mehr oder weniger stark geschädigt wird, wodurch ein einwandfreier Auflagendruck nicht mehr möglich wird.

Aufgabe der vorliegenden Erfindung ist es deshalb, eine Einbrenngummierung vorzuschlagen, die die genannten Nachteile nicht aufweist, die verhindert, daß sich während des Erhitzens der Druckform Verunreinigungen auf der Plattenoberfläche niederschlagen, die die Druckform während der Lagerung gegen Verschmutzung schützt und die nichtdruckenden Oberflächenbereiche dauerhaft hydrophil hält.

Die Erfindung geht aus von einer Einbrenngummierung für bestrahlte und entwickelte Offsetdruckplatten, bestehend aus Wasser und einem wasserlöslichen Polymeren oder Copolymeren. Die erfindungsgemäße Einbrenngummierung ist dann dadurch gekennzeichnet, daß das Polymere oder Copolymere Sulfonsäuregruppen und/oder Alkali- oder Ammoniumsulfonatgruppen besitzt.

Gemäß der Erfindung eignen sich besonders Polymere oder Copolymere, die Styrol- und/oder Methylstyrolsulfonsäuren in Form ihrer wasserlöslichen Salze als Monomereinheiten enthalten. Geeignet sind ferner Polymere, die aliphatische Sulfonsäuregruppen als solche oder in Form ihrer wasserlöslichen Salze in Monomereinheiten enthalten, wie z.B. Polyvinylphosphonsäure und deren Alkalisalze, oder Copolymere, die Vinylsulfonsäure oder Acrylamidopropansulfonsäuren oder deren Salze als Monomereinheiten enthalten. Geeignet sind auch Polymere, bestehend aus einem teilverseiften oder vollständig verseiften Polyvinylacetat, wobei die Polyvinylalkoholeinheiten teilweise mit Butyraldehyd-4-sulfonsäure acetalisiert sind.

Die erfindungsgemäßen Polymeren oder Copolymeren haben bevorzugt ein Molekulargewicht zwischen 1.500 und 500.000.

Das gemäß der Erfindung verwendete Polymere oder Copolymere faßt von der Wirkung her die bisher in den bekannten Einbrenngummierungen eingesetzten Komponenten a) zur Vermeidung der Hintergrundverunreinigungen während des Einbrennens und b) zur Konservierung der Druckform zwecks Lagerung über einen längeren Zeitraum in einer einzigen Komponente zusammen. Die Einbrenngummierung gemäß der Erfindung enthält insbesondere 1 bis 50 Gew.-%, bevorzugt 3 bis 20 Gew.-%, des Alkali- oder Ammoniumsalzes eines sulfurierten Polystyrols.

In verschiedenen Varianten kann die Einbrenngummierung auch noch Hydroxypolycarbonsäuren, wie Citronensäure und/oder deren Salze, in einem Anteil von 0,10 bis 5 %, und Tenside (bevorzugt anionogene oder nichtionogene Tenside) wie Alkylarylsulfonate (z.B. Di-Na-diisobutylnaphthalin-disulfonat) oder ein natürliches Tensid (z.B. Saponin) in einem Anteil von 0,01 bis 5 % enthalten.

Bei der Anwendung der Einbrenngummierung kann so verfahren werden, daß man die Oberfläche oder - bei doppelter Beschichtung mit einer Reproduktionsschicht - beide Oberflächen der bestrahlten und entwickelten Offsetdruckplatte mit einem Tampon einreibt, der mit der Einbrenngummierung getränkt wurde. Es sind jedoch auch andere Arten des Aufbringens, wie Tauchen, Aufsprühen, Aufschleudern oder Aufgießen, möglich, wobei dies sowohl von Hand als auch in automatischen Verarbeitungsmaschinen durchgeführt werden kann. Zweckmäßig wird die Oberfläche der mit der Einbrenngummierung versehenen Druckplatte vor dem Einbrennen getrocknet. Das Trocknen kann aber auch während des nachfolgenden Einbrennens erfolgen.

Das Schichtgewicht der Einbrenngummierung liegt nach dem Trocknen im allgemeinen im Bereich von 0,05 bis 20 g/m². Die so behandelte Druckplatte wird anschliessend in einem Einbrennofen bei einer Temperatur von 150 bis 300 °C, insbesondere von 200 bis 230 °C, eingebrannt, wobei übliche Einbrennzeiten bei 0,5 bis 10 min liegen. Neben den in der Praxis eingesetzten Heißluftöfen sind in jüngster Zeit auch andere Behandlungsarten beschrieben worden, beispielsweise eine Bestrahlung mit Quarz-Halogen-Lampen gemäß der DE-C 19 55 378, mit Infrarot-Strahlung gemäß der DE-C 22 01 936 oder mit UV-Lampen gemäß der DE-A 31 10 632.

Mit der erfindungsgemäßen Einbrenngummierung lassen sich die üblichen in der Praxis anzutreffenden Offsetdruckplatten aus Metall und/oder temperaturstabilem Kunststoff behandeln, insbesondere ist sie jedoch geeignet für solche Offsetdruckplatten, die ein mechanisch, chemisch und/oder elektrochemisch aufgerauhtes und gegebenenfalls anodisch oxidiertes Trägermaterial aus Aluminium oder einer seiner Legierungen aufweisen. Diese Trägermaterialien können negativ- oder positivarbeitende Reproduktionsschichten tragen, die eine der bekannten strahlungsempfindlichen Verbindungen wie Diazo-, Diazonium- oder Azidoverbindungen oder photopolymerisierbare Verbindungen enthalten (siehe z.B. in Jaromir Kosar, "Light-Sensitive Systems", John Wiley & Sons, New York, 1965). Insbesondere ist die erfindungsgemäße Einbrenngummierung aber für positiv-arbeitende Reproduktionsschichten geeignet, die im allgemeinen neben der eigentlichen strahlungsempfindlichen Verbindung noch Harze, insbesondere Novolake oder Resole, aber auch verschiedene weitere Komponenten wie Farbstoffe, Haftvermittler oder Verlaufmittel enthalten. Zu den strahlungsempfindlichen Verbindungen in diesen Reproduktionsschichten zählen insbesondere die o-Chinondiazide, bevorzugt o-Naphthochinondiazide wie Naphthochinon-(1,2)-diazid-(2)sulfonsäureester oder -amide, die nieder- oder höhermolekular sein können, siehe dazu beispielsweise die DE-C 854 890, 865 109, 879 203, 894 959, 938 233, 11 09 521, 11 44 705, 11 18 606, 11 20 273, 11 24 817 und 23 31 377 und die EP-A 0 021 428 und 0 055 814.

Für positiv arbeitende Kopierschichten lassen sich auch Materialien auf der Basis von säurespaltbaren Verbindungen mit gutem Erfolg einsetzen. Kopiermaterial dieser Art ist bekannt und beispielsweise in den US-A 3 779 778 und 4 101 323, der DE-C 27 18 254 und den DE-A 29 28 636, 28 29 512 und 28 29 511 beschrieben. Sie erhalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine oder 2-Trichlormethyl-1,3,4-oxadiazole.

Die erfindungsgemäße Einbrenngummierung bewirkt den von den Einbrennhilfen her bekannten Effekt einer leichten Entfernungsmöglichkeit der Verunreinigung in den Nichtbildstellen von Offsetdruckplatten. Zusätzlich macht sie aber ein Abwaschen der aufgebrachten Schutzschicht und/oder ein Auftragen oder Erneuern/Auffrischen einer Gummierung (Konservierung) überflüssig. Eine mit der erfindungsgemäßen Einbrenngummierung versehene Druckform läuft sich in der Druckmaschine in überraschend kurzer Zeit frei und gewährleistet eine schnelle Farbannahme der Bildstellen bei gleichzeitiger Tonfreiheit der Nichtbildstellen.

Besonders vorteilhaft ist, daß im Gegensatz zu den bisher bekannten Einbrennhilfsmitteln sowohl die während des Einbrennvorgangs auftretenden Hintergrundverunreinigungen verhindert werden als auch eine dauerhafte Konservierung der Druckform mit nur einer einzigen Komponente erreicht wird. Von Vorteil ist ferner, daß die erfindungsgemäßen Einbrenngummierungen keine schwer löslichen Erdalkalisalze bilden, so daß keine weiteren Komplexbildner, wie z.B. Nitrilotriessigsäure, die sehr oft die Ursache für den Schichtangriff während des Einbrennens sind, der Einbrenngummierung zugesetzt werden müssen.

In der vorstehenden Beschreibung und den nachfolgenden Beispielen bedeuten %-Angaben, wenn nichts anderes angegeben ist, immer Gew.-%, Gew.-Teile stehen zu Vol.-Teilen im Verhältnis von g zu cm$^3$.

Beispiel 1

Mit einem positiv arbeitenden strahlungsempfindlichen Gemisch aus
1,200 Gew.-Teilen des Veresterungsproduktes aus 1 mol des Ethoxyethylesters der 4,4-Bis-(4-hydroxyphenyl)-n-valeriansäure und 2 mol Naphthochinon-(1,2)-diazid-(2)-5-sulfonsäurechlorid,
6,800 Gew.-Teilen eines durch Kondensation eines technischen Kresolgemisches mit Formaldehyd hergestellten Novolaks vom Schmelzpunkt 108 bis 118 °C,
0,070 Gew.-Teilen Kristallviolett,
0,200 Gew.-Teilen Naphtochinon-(1,2)-diazid-(2)-4-sulfonsäurechlorid in
50,00 Gew.-Teilen Ethylenglykolmonomethylether und 50,00 Gew.-Teilen Tetrahydrofuran
wird eine elektrochemisch aufgerauhte und anodisierte Aluminiumplatte beschichtet. Der anodisierte Träger war vor dem Aufbringen der lichtempfindlichen Kopierschicht mit einer wäßrigen Lösung von 0,1 Gew.-% Polyvinylphosphonsäure behandelt worden.

Die so hergestellte Offsetdruckplatte mit einem Gewicht der Reproduktionsschicht von 2,30 g/m$^2$ wird unter einer transparenten Positivvorlage bildmäßig belichtet und anschließend mit der folgenden Lösung entwickelt:
5,3 Gew.-Teile Na$_2$SiO$_3$ . 9 H$_2$O
3,4 Gew.-Teile Na$_3$PO$_4$ . 12 H$_2$O
0,3 Gew.-Teile NaH$_2$PO$_4$ wasserfrei in
91,0 Gew.-Teilen H$_2$O.

Durch die Entwicklung werden die vom Licht getroffenen Anteile der Reproduktionsschicht entfernt, und es bleiben die unbelichteten Teile als Bildstellen auf dem Trägermaterial zurück, so daß eine der Vorlage entsprechende Druckschablone erhalten wird. Von einer so hergestellten Druckform können in einer Druckmaschine etwa 100.000 einwandfreie Drucke erhalten werden. Um ein Mehrfaches dieser Auflagenhöhe zu erreichen, muß die Druckplatte noch in an sich bekannter Weise eingebrannt werden. Zu diesem Zweck wird die belichtete und entwickelte Druckplatte mit Hilfe eines Tampons mit der folgenden Einbrenngummierung, bestehend aus einer 5%igen wäßrigen Lösung des Natriumsalzes einer Polystyrolsulfonsäure mit einem Molekulargewicht von ca. 70.000 überwischt und getrocknet, wobei man darauf achtet, daß ein über die gesamte Oberfläche der Druckform zusammenhängender Film gebildet wird.

Anschließend wird die mit der Schutzschicht versehene Druckform während 5 min bei 230 °C in einem handelsüblichen Heißluftofen eingebrannt. Die so hergestellte Druckform kann sofort in die Druckmaschine eingespannt und dem üblichen Druckvorgang unterworfen werden, ohne daß es erforderlich ist, die Schutzschicht vorher mit Wasser zu entfernen und/oder die Druckform gegebenenfalls erneut mit einem Konservierungsmittel, wie beispielsweise Gummi arabicum, zu behandeln. Bereits nach 4 Umläufen der Feucht- und Farbwalzen der Druckmaschine wird eine vollständige Farbannahme der Druckschablone bei gleichzeitiger Tonfreiheit des Hintergrundes erreicht, so daß nach spätestens 6 Bogen Papier ("Makulatur") ein einwandfreier Druck erhalten wird.

Ersetzt man die im Beispiel 1 erfindungsgemäß verwendete Einbrenngummierung durch eines der Beispiele nach der EP-A 0 155 620, so wird unter gleichen Versuchsbedingungen ein einwandfreier Druck erst nach 15 bis 20 Bogen Papier (Makulatur) erhalten. Auch bei realtiv dicker Konservierung der Druckform mit der im Beispiel 1 angegebenen Einbrenngummierung wird die Druckschablone während des Einbrennvorgangs nicht beschädigt, so daß auch während des Fortdrucks eine einwandfreie Farbannahme gewährleistet ist. Demgegenüber zeigen die nach EP-A 0 155 620 angegebenen Einbrennhilfsmittel bei zu dicker Konservierung - vor allem an den Stellen, wo Tropfen der Einbrenngummierung nicht verteilt, sondern angetrocknet stehengeblieben sind - starke Schichtangriffe während des Einbrennens.

Wird unter gleichen Versuchsbedingungen eine entsprechend Beispiel 1 hergestellte vorsensibilisierte Offsetdruckplatte vor dem Einbrennen mit einer wäßrigen Lösung aus 7 % Gummi arabicum und 22 % Di-Na-dodecylphenoxybenzoldisulfonat nach Beispiel 1 der GB-A 1 575 200 behandelt und die so vorbehandelte Druckplatte eingebrannt und ohne Abwaschen der Schutzschicht in die Druckmaschine eingespannt, so wird auch nach dem Durchlaufenlassen von 100 Bogen Papier noch kein einwandfreier Andruck erhalten. Ein ähnlich unbefriedigendes Resultat wird erhalten, wenn anstelle von Gummi arabicum Na-carboxymethylcellulose verwendet wird.

Auch nach der DE-A 26 26 473 oder DE-C 26 25 336 mit beispielsweise Na$_2$B$_4$O$_7$ oder Na$_2$HPO$_4$ als Einbrennhilfe hergestellte Druckformen können keinen einwandfreien Andruck ergeben, wenn die entsprechenden Schutzschichten nicht vor dem eigentlichen Druckvorgang mit Wasser abgewaschen werden.

Ein weiterer Vorteil der gemäß der Erfindung verwendeten Polystyrolsulfonsäuren ist, daß letztere gut lösliche Erdalkalisalze bilden, so daß auch bei Zugabe großer Mengen von relativ hartem Wasser keine Trübungen in den Einbrenngummierungen entstehen, im Gegensatz zu vielen der bisher beanspruchten Einbrennhilfsmittel, bei denen organische Carbon-, Sulfon- oder Phosphonsäuren verwendet werden, die alle mehr oder weniger schwer lösliche Erdalkalisalze bilden. Versetzt man beispielsweise 1 ml der im Beispiel 3 gemäß EP-A 0 155 620 oder 1 ml der im Beispiel 2 gemäß GB-A 1 513 368 angegebenen Einbrennhilfsmittel mit 100 ml Wasser mit dem Härtegrad DH 35, so entsteht bereits nach kurzem Stehen eine starke Trübung, während unter gleichen Versuchsbedingungen mit der erfindungsgemäß beanspruchten Einbrenngummierung auch nach Zugabe von 1000 ml des gleichen Wassers keine Trübung zu beobachten ist. Derartige Trübungen oder Ausfällungen in den Einbrenngummierungen können insbesondere bei den automatischen Verarbeitungsanlagen auftreten, wo Belichtung, Entwicklung und Konservierung in einem Arbeitsgang durchgeführt werden, verursacht durch mitgeschleppte Entwickler- und/oder Wasserreste aus den vorgeschalteten Tanks.

Die mit der erfindungsgemäßen Einbrenngummierung versehene eingebrannte Druckplatte kann auch über einen Zeitraum von mehreren Monaten bei Raumtemperatur gelagert werden, ohne daß bei einem später eingeleiteten Druckvorgang Nachteile, wie z. B. auftretender Ton an den bildfreien Flächen, eintreten.

In den folgenden Beispielen werden weitere Einbrenngummierungen angegeben, mit denen die nach Beispiel 1 hergestellte Druckplatte vor dem Einbrennen behandelt wird, wobei ähnlich wie im Beispiel 1 in relativ kurzer Zeit in der Druckmaschine ein einwandfreier Druck erhalten wird. Wenn nicht gesondert vermerkt, entsprechen Herstellung und Verarbeitung der damit erhaltenen Druckplatten den in Beispiel 1 beschriebenen Bedingungen.

Beispiel 2

Es wird folgende Einbrenngummierung eingesetzt:
3,00 Gew.-Teile des Natriumsalzes einer Polystyrolsulfonsäure mit einem Molekulargewicht von ca. 500.000
97,00 Gew.-Teile Wasser dest.

Beispiel 3

Es wird folgende Einbrenngummierung eingesetzt:
4,00 Gew.-Teile des Natriumsalzes einer Polystyrolsulfonsäure gemäß Beispiel 1
1,00 Gew.-Teile Kaliumcitrat
0,20 Gew.-Teile Citronensäure,
94,80 Gew.-Teile Wasser dest.

Beispiel 4

Es wird folgende Einbrenngummierung eingesetzt:
3,00 Gew.-Teile des Natriumsalzes einer Polystyrolsulfonsäure gemäß Beispiel 2
0,05 Gew.-Teile Natriumsalz der 1,2-Isopropylnaphthalinsulfonsäure (anionogenes Tensid)
96,95 Gew.-Teile Wasser dest.

Beispiel 5

Es wird folgende Einbrenngummierung eingesetzt:
4,00 Gew.-Teile eines Copolymerisats aus Styrolsulfonsäure (Na-Salz) und Maleinsäureanhydrid im Verhältnis 3:1
2,00 Gew.-Teile Kaliumcitrat
0,50 Gew.-Teile Citronensäure
93,50 Gew.-Teile Wasser dest.

Beispiel 6

Es wird folgende Einbrenngummierung eingesetzt:
5,00 Gew.-Teile eines teilverseiften Polyvinylacetats, dessen alkoholische Gruppen mit Butyraldehyd-4-sulfonsäure acetalisiert sind.
95,00 Gew.-Teile Wasser dest.

Beispiel 7

Es wird folgende Einbrenngummierung eingesetzt:
3,00 Gew.-Teile eines Copolymerisats bestehend aus
20 % Acrylamidopropansulfonsäure und 80 % Vinylphosphonsäure,
97,00 Gew.-Teile Wasser dest.

Beispiel 8

Es wird folgende Einbrenngummierung eingesetzt:
5,00 Gew.-Teile eines Copolymerisats bestehend aus 40 % Vinylsulfonsäure und 60 % Vinylphosphonsäure
95,00 Gew.-Teile Wasser dest.

**Patentansprüche**

1. Einbrenngummierung für bestrahlte und entwickelte Offsetdruckplatten, bestehend aus Wasser und einem wasserlöslichen Polymeren oder Copolymeren zum Schutz der Plattenoberfläche während des Einbrennvorgangs sowie bei Langzeitlagerung, dadurch gekennzeichnet, daß das Polymere oder Copolymere Sulfonsäuregruppen und/oder Alkali- oder Ammoniumsulfonatgruppen besitzt.

2. Einbrenngummierung nach Anspruch 1, dadurch gekennzeichnet, daß das Polymere oder Copolymere Styrol- und/oder Methylstyrolsulfonsäuren als solche oder in Form ihrer wasserlöslichen Salze als Monomereinheiten enthält.

3. Einbrenngummierung nach einem der Ansprüche 1 oder 2, dadurch gekennzeichnet, daß das Polymere das Alkali- oder Ammoniumsalz eines sulfurierten Polystyrols ist.

4. Einbrenngummierung nach einem der Ansprüche 1 oder 2, dadurch gekennzeichnet, daß das Copolymere aus dem Alkali- oder Ammoniumsalz eines sulfurierten Styrols und Maleinsäureanhydrid besteht.

5. Einbrenngummierung nach Anspruch 1, dadurch gekennzeichnet, daß das Polymere oder Copolymere aliphatische Sulfonsäuregruppen als solche oder in Form ihrer wasserlöslichen Salze in Monomereinheiten enthält.

6. Einbrenngummierung nach einem der Ansprüche 1 oder 5, dadurch gekennzeichnet, daß das Polymere aus Polyvinylsulfonsäure oder deren Alkali- oder Ammoniumsalzen besteht.

7. Einbrenngummierung nach einem der Ansprüche 1 oder 5, dadurch gekennzeichnet, daß das Copolymere Vinylsulfonsäure oder Acrylamidopropansulfonsäure oder deren Salze als Monomereinheiten enthält.

8. Einbrenngummierung nach Anspruch 1, dadurch gekennzeichnet, daß das Polymere oder Copolymere Acetalgruppierungen, gebildet aus einer Aldehydsulfonsäure, enthält.

9. Einbrenngummierung nach einem der Ansprüche 1 oder 8, dadurch gekennzeichnet, daß das Polymere aus einem teilverseiften oder vollständig verseiften Polyvinylacetat besteht und die Polyvinylalkoholeinheiten zumindest teilweise mit Butylaldehyd-4-sulfonsäure acetalisiert sind.

10. Einbrenngummierung nach einem der Ansprüche 1 bis 9, dadurch gekennzeichnet, daß das Polymere oder Copolymere ein Molgewicht von 1.500 bis 500.000 aufweist.

11. Einbrenngummierung nach einem der Ansprüche 1 bis 10, dadurch gekennzeichnet, daß der Anteil an dem Polymeren oder Copolymeren in der wäßrigen Lösung 1 bis 50 Gew.-%, bevorzugt 3 bis 20 Gew.-%, beträgt.

12. Einbrenngummierung nach einem der Ansprüche 1 bis 11, dadurch gekennzeichnet, daß sie zusätzlich ein Tensid und/oder eine Hydroxypolycarbonsäure und/oder deren wasserlösliche Salze in einem Anteil von 0,10 bis 5 Gew.-% enthält.

**Claims**

1. A burn-in gumming for irradiated and developed offset printing plates, composed of water and a water-soluble polymer or copolymer for protecting the plate surface during the burning-in step and on long-term storage, where in the polymer or copolymer contains sulfonic acid groups and/or alkali metal sulfonate or ammonium sulfonate groups.

2. A burn-in gumming as claimed in claim 1, wherein the polymer or copolymer contains, as the monomer units, styrenesulfonic and/or methylstyrenesulfonic acids as such or in the form of their water-soluble salts.

3. A burn-in gumming as claimed in claim 1 or 2, wherein the polymer is the alkali metal or ammonium salt of a sulfonated polystyrene.

4. A burn-in gumming as claimed in claim 1 or 2, wherein the copolymer is composed of the alkali metal or ammonium salt of a sulfonated styrene and maleic anhydride.

5. A burn-in gumming as claimed in claim 1, wherein the polymer or copolymer contains, in monomer units, aliphatic sulfonic acid groups as such or in the form of their water-soluble salts.

6. A burn-in gumming as claimed in claim 1 or 5, wherein the polymer is composed of polyvinylsulfonic acid or the alkali metal or ammonium salts thereof.

7. A burn-in gumming as claimed in claim 1 or 5, wherein the copolymer contains, as the monomer units, vinyl-sulfonic acid or acrylamidopropanesulfonic acid or salts thereof.

8. A burn-in gumming as claimed in claim 1, wherein the polymer or copolymer contains acetal groupings formed from an aldehydesulfonic acid.

9. A burn-in gumming as claimed in claim 1 or 8, wherein the polymer is composed of partially or fully saponified polyvinyl acetate and the polyvinyl alcohol units are at least partially acetalized with butyl-aldehyde-4-sulfonic acid.

10. A burn-in gumming as claimed in any of claims 1 to 9, wherein the polymer or copolymer has a molecular weight from 1,500 to 500,000.

11. A burn-in gumming as claimed in any of claims 1 to 10, wherein the proportion of polymer or copolymer in the aqueous solution is 1 to 50% by weight, preferably 3 to 20% by weight.

12. A burn-in gumming as claimed in any of claims 1 to 11, which additionally contains 0.10 to 5% by weight of a surfactant and/or a hydroxypolycarboxylic acid and/or water-soluble salts thereof.

## Revendications

1. Composition de gommage par cuisson pour plaques d'impression offset irradiées et développées, constituée d'eau et d'un polymère ou copolymère soluble dans l'eau, pour la protection de la surface de la plaque pendant l'opération de cuisson ainsi que lors d'un stockage à long terme, caractérisée en ce que le polymère ou copolymère possède des groupes acide sulfonique et/ou des groupes sulfonate alcalin ou d'ammonium.

2. Composition de gommage par cuisson selon la revendication 1, caractérisée en ce que le polymère ou copolymère contient,en tant que motifs monomères, de l'acide styrènesulfonique et/ou de l'acide méthylstyrènesulfonique en tant que tels ou sous forme de leurs sels solubles dans l'eau.

3. Composition de gommage par cuisson selon la revendication 1 ou 2, caractérisée en ce que le polymère est le sel alcalin ou d'ammonium d'un polystyrène sulfoné.

4. Composition de gommage par cuisson selon la revendication 1 ou 2, caractérisée en ce que le copolymère est constitué du sel alcalin ou d'ammonium d'un styrène sulfoné et d'anhydride maléique.

5. Composition de gommage par cuisson selon la revendication 1, caractérisée en ce que le polymère ou copolymère contient, en tant que motifs monomères,des groupes acide sulfonique aliphatique tels quels ou sous forme de leurs sels solubles dans l'eau.

6. Composition de gommage par cuisson selon la revendication 1 ou 5, caractérisée en ce que le polymère est constitué d'acide polyvinylsulfonique ou de ses sels alcalins ou d'ammonium.

7. Composition de gommage par cuisson selon la revendication 1 ou 5, caractérisée en ce que le copolymère contient, en tant que motifs monomères, l'acide vinylsulfonique ou l'acide acrylamidopropanesulfonique ou leurs sels.

8. Composition de gommage par cuisson selon la revendication 1, caractérisée en ce que le polymère ou copolymère contient des groupements acétals, formés à partir d'un acide aldéhyde-sulfonique.

9. Composition de gommage par cuisson selon la revendication 1 ou 8, caractérisée en ce que le polymère est constitué d'un poly(acétate de vinyle) partiellement saponifié ou totalement saponifié, et les motifs poly(alcool vinylique) sont au moins partiellement acétalisés avec l'acide butylaldéhyde-4-sulfonique.

10. Composition de gommage par cuisson selon l'une des revendications 1 à 9, caractérisée en ce que le polymère ou copolymère a une masse moléculaire de 1 500 à 500 000.

11. Composition de gommage par cuisson selon l'une des revendications 1 à 10, caractérisée en ce que la proportion du polymère ou copolymère dans la solution aqueuse va de 1 à 50 % en poids, de préférence de 3 à 20 % en poids.

12. Composition de gommage par cuisson selon l'une des revendications 1 à 11, caractérisée en ce qu'elle contient en outre un surfactif et/ou un acide hydroxypolycarboxylique et/ou leurs sels solubles dans l'eau, en une proportion de 0,10 à 5 % en poids.